(19) Europäisches Patentamt
European Patent Office
Office européen des brevets

(11) **EP 3 076 249 B1**

(12) **EUROPÄISCHE PATENTSCHRIFT**

(45) Veröffentlichungstag und Bekanntmachung des Hinweises auf die Patenterteilung:
**10.04.2019 Patentblatt 2019/15**

(51) Int Cl.:
**G05B 19/042** *(2006.01)*    **G05B 23/02** *(2006.01)*
**G08C 19/02** *(2006.01)*

(21) Anmeldenummer: **16154999.3**

(22) Anmeldetag: **10.02.2016**

(54) **VERFAHREN ZUM BETREIBEN EINES FELDGERÄTES UND ENTSPRECHENDES FELDGERÄT**

METHOD FOR OPERATING A FIELD DEVICE AND CORRESPONDING FIELD DEVICE

PROCÉDÉ DE FONCTIONNEMENT D'UN APPAREIL DE TERRAIN ET APPAREIL DE TERRAIN CORRESPONDANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.04.2015  DE 102015105090**

(43) Veröffentlichungstag der Anmeldung:
**05.10.2016  Patentblatt 2016/40**

(73) Patentinhaber: **Krohne Messtechnik GmbH**
**47058 Duisburg (DE)**

(72) Erfinder: **Kunze, Johannes**
**44892 Bochum (DE)**

(74) Vertreter: **Gesthuysen Patent- und Rechtsanwälte**
**Patentanwälte**
**Huyssenallee 100**
**45128 Essen (DE)**

(56) Entgegenhaltungen:
**EP-A1- 1 206 732     DE-A1- 19 930 661**
**US-A1- 2005 168 343**

EP 3 076 249 B1

**Beschreibung**

Die Erfindung betrifft ein Verfahren zum Betreiben eines Feldgerätes, wobei ein Messwert erzeugt wird und wobei dem Messwert ein Strom-Soll-Wert zugeordnet wird. Abhängig von dem Strom-Soll-Wert wird ein Soll-Strom-Signal ausgegeben. Ein Ist-Strom-Signal wird eingelesen und das Soll-Strom-Signal mit dem Ist-Strom-Signal verglichen. Darüber hinaus betrifft die Erfindung ein Feldgerät mit mindestens einem Signalausgang und mit mindestens einer Steuerkomponente. Das Feldgerät erzeugt einen Messwert und die Steuerkomponente ordnet dem Messwert einen Strom-Soll-Wert zu. Abhängig vom Strom-Soll-Wert erzeugt die Steuerkomponente ein Soll-Strom-Signal. Das Soll-Strom-Signal wird über den Signalausgang ausgegeben und die Steuerkomponente liest ein Ist-Strom-Signal ein. Die Steuerkomponente vergleicht das Soll-Strom-Signal mit dem Ist-Strom-Signal.

Im Bereich der modernen Prozessautomatisierung werden zumeist Feldgeräte zur Überwachung von Prozessgrößen und Aktoren für die Beeinflussung der Prozesse verwendet. Für den Fall, dass es sich bei den Feldgeräten um Messgeräte handelt, die Füllstände, Durchflüsse, Temperaturen oder pH-Werte messen, entsprechen die vom Feldgerät ausgegebenen Signale jeweils den gewonnenen Messwerten. Über gegebenenfalls spezielle Ausgänge werden Signale ausgegeben, die auch Aussagen über den Zustand des Feldgerätes, beispielsweise Fehlersignale, übermitteln.

Konventionell wird für die Signalisierung der Standard der 4...20 mA-Signale verwendet. Dabei werden Feldgeräte über 4...20mA Stromschleifen (Normsignal) mit einer übergeordneten Einheit verbunden bzw. an Regler und Steuerungen mit einem solchen Normalsignalausgang angeschlossen. Neben der Signalübertragung dienen diese Stromsignale bei der 2-Leiter-Technik der Energieversorgung der Feldgeräte. Für die Zuordnung von Signalen werden den beiden Grenzwerten von 4 mA und 20 mA meist der kleinste bzw. größte zu erwartende Messwert zugeordnet. Für die Messwerte, die dazwischen liegen, wird zumeist eine lineare Zuordnung vorgenommen. Im Falle eines im Feldgerät erkannten Fehlers werden standardgemäß Stromwerte außerhalb des Bereichs zwischen 4 mA und 20 mA ausgegeben.

Problematisch ist es, wenn das Feldgerät zwar einen Wert zwischen 4...20 mA ausgibt, dieser Wert aber fehlerhafterweise nicht dem eingestellten Wert entspricht, der dem korrespondierenden Messwert zugeordnet wurde.

Dazu ist es im Stand der Technik bekannt, dass ein vom Feldgerät ausgegebenes Strom-Signal rückgelesen und mit dem eingestellten Strom-Wert verglichen wird.

Die DE 199 30 661 A1 zeigt beispielsweise einen Messumformer mit einer Recheneinheit. Ein von einem Sensor erfasstes Signal wird zunächst digitalisiert und dann der Recheneinheit zugeführt. Die Recheneinheit bereitet das erfasste Signal zu einem Soll-Wert auf. Der Soll-Wert wird anschließend in ein analoges Signal umgewandelt und über einen Signalausgang ausgegeben. Dieses analoge Signal wird rückgelesen und in digitalisierter Form wieder an die Recheneinheit übertragen. Die Recheneinheit ermittelt eine Abweichung zwischen dem Soll-Wert und dem Ausgangssignal.

Auf dem Gebiet der Übertragungsprotokolle werden beispielsweise Signale mit anderen Signalen überlagert oder gefiltert und sind so nur mit Mühe mit dem ursprünglich ausgegebenen Signal zu vergleichen.

Ein Beispiel ist die weit verbreitete HART-Kommunikation. HART (Highway Adressable Remote Transducer) ist ein Protokoll für busadressierte Feldgeräte. Es ist eine Variante der digitalen Feldkommunikation, die viele Funktionalitäten von Feldbussen beinhaltet. Bei der HART-Kommunikation werden Feldgeräte konventionell nach dem 4...20mA-Standard angeschlossen und mit einer übergeordneten Einheit verbunden. Dem analogen 4...20mA-Signal wird im FSK Verfahren (Frequency Shift Keying) ein digitales Signal aufmoduliert. Somit können zusätzlich Mess-, Stell- und Gerätedaten übertragen werden, ohne das Analogsignal zu beeinflussen. Zusätzlich wird über das HART-Protokoll eine umfassende Integration der Feldgeräte in Prozessleitsysteme ermöglicht.

Gerade bei dem bekannten HART-Standard, bei dem einem niederfrequenten, analogen Signal hochfrequente Signale überlagert werden, ist es üblich, dass ein analoger Tiefpass zur Bandbegrenzung verwendet wird. Dadurch werden höhere Frequenzen des 4...20 mA Signals ausgefiltert. Für den Fall, dass ungefilterte Signale mit einem hochfrequenten Signal nach dem HART-Standard überlagert werden, ist es schwierig, höhere Frequenzen eines breiten Frequenzspektrums von den hochfrequenten Überlagerungen zu unterscheiden. Durch die Verwendung eines analogen Tiefpasses wird die Kommunikation insgesamt vereinfacht.

Wird nun das Signal rückgelesen, muss das überlagerte Signal möglicherweise mit einem digitalen Filter entfernt werden. Durch die Umwandlung des analogen in ein digitales Signal und das analoge Filter treten zeitliche Verzögerungen zwischen den zu vergleichenden Signalen auf, die bei einem Vergleich der Signale berücksichtigt werden müssen.

Der Erfindung liegt daher die Aufgabe zugrunde, ein Verfahren zum Betreiben eines Feldgerätes - und ein entsprechendes Feldgerät - anzugeben, das eine zuverlässige Signalausgabe ermöglicht und dies insbesondere auch bei der Verwendung des HART-Protokolls.

Das erfindungsgemäße Verfahren, bei dem die zuvor hergeleitete und aufgezeigte Aufgabe gelöst ist, ist zunächst und im Wesentlichen dadurch gekennzeichnet, dass für den Vergleich eine Kreuzkorrelation des Soll-Strom-Signals mit dem Ist-Strom-Signal gebildet wird. Durch die Kreuzkorrelation werden die Signale, auch wenn sie zeitlich verschoben sind, leicht und präzise vergleichbar.

Die Kreuzkorrelation ist definiert als das Integral über die Zeit zweier miteinander multiplizierten Zeitfunktionen x(t) und y(t), wobei eine der Funktionen zeitlich um einen festgelegten Wert τ zur anderen verschoben wird. Wenn nun beide Funktionen im Wesentlichen gleich sind, aber lediglich zeitlich um einen Wert $τ_1$ verschoben sind, so wird die Korrelationsfunktion ein Maximum für $τ=τ_1$ haben.

In der Praxis liegen Signale nicht als mathematische Funktionen, sondern als diskrete Zeitsignale vor, das heißt Werte $x_i$, $y_i$ zu diskreten Zeitpunkten $i=1...N$. Somit ist es möglich, den Übergang des Integrals in eine Summe darzustellen (i entspricht t und k entspricht τ). Wird das Ergebnis durch den Effektivwert der einzelnen Signale dividiert, spricht man von einer normierten Kreuzkorrelation:

$$corr(k) = \frac{\sum_{i=1}^{N} x(i) \cdot y(i+k)}{\sqrt{\sum_{i=1}^{N}(x(i))^2 \cdot \sum_{i=1}^{N}(y(i+k))^2}}$$

Sind die Signale für ein k gleich, liefert die normierte Kreuzkorrelation den Wert 1. Sind die Signale gegenphasig, liefert sie den Wert -1. Von unkorrelierten Signalen spricht man, wenn der Wert der normierten Korrelation für alle k gleich Null ist.

Für die Auswertung und den Vergleich der ausgegebenen und rückgelesenen Signale bei dem erfindungsgemäßen Verfahren zum Betreiben eines Feldgerätes wird die Kreuzkorrelation verwendet. So ist es möglich, Signale zu vergleichen, die möglicherweise aufgrund von zeitlichen Verzögerungen durch Konvertierungen, Filtern oder sonstigen Maßnahmen zueinander versetzt sind. Darüber hinaus werden auch Signale, die nicht identisch sind oder sich nicht ähneln, effektiv verglichen, so dass das Ergebnis der Kreuzkorrelation Aussagen darüber erlaubt, ob ein Soll-Strom-Signal einem Ist-Strom-Signal entspricht.

Dadurch ist es bei diesem Verfahren möglich, dass Signalen andere Signale wie zum Beispiel Signale nach dem HART-Kommunikationsprotokoll überlagert werden. Auch bei nachträglichem Ausfiltern der HART-Signale für einen akkuraten Signalvergleich kann durch die Kreuzkorrelation ein zeitlicher Versatz der Signale zueinander, die ein solches Ausfiltern verursacht, ausgeglichen werden.

In einer Ausgestaltung des erfindungsgemäßen Verfahrens ist es vorgesehen, dass eine Autokorrelation des Soll-Strom-Signals oder des Ist-Strom-Signals gebildet wird und dass eine Abweichung e der korrelierten Signale berechnet wird, wobei die Werte der Kreuzkorrelation des Ist-Strom-Signals mit dem Soll-Strom-Signal mit dem Wert der Autokorrelation des Strom-Soll-Wertes oder dem Wert der Autokorrelation des Ist-Strom-Signals zueinander ins Verhältnis gesetzt werden.

Eine Autokorrelation einer Funktion oder eines Signals erhält man, wenn man ein Signal, wie oben beschrieben, mit sich selbst korreliert. Die Autokorrelation ist eine Art Selbstanalyse eines Signals und kann beispielsweise genutzt werden, um Periodizitäten in dem Signal aufzufinden.

Bei dieser Ausgestaltung der Erfindung wird folglich eine relative Abweichung des Soll-Strom-Signals vom Ist-Strom-Signal bestimmt. Dabei kann zwischen der Autokorrelation des Soll-Strom-Signals und der Autokorrelation des Ist-Strom-Signals gewählt werden. Das Ergebnis der Kreuzkorrelation wird mit dem Ergebnis der Autokorrelation des Soll-Strom-Signals oder des Ist-Strom-Signals ins Verhältnis gesetzt. Je näher das Ergebnis der Division am Wert 1 liegt, desto ähnlicher sind sich folglich Soll-Strom-Signal und Ist-Strom-Signal. Prinzipiell muss sich das Verhältnis nicht auf eine Autokorrelation von Ist-Strom-Signal oder Soll-Strom-Signal beschränken.

Untersuchungen der Anmelderin haben ergeben, dass das Verfahren durch die Berechnung der Korrelationen selbst bei großen Transienten im Stromverlauf, ausgelöst beispielsweise von Stromstößen, noch zuverlässig arbeitet.

Mit der ermittelten Abweichung e können andere Ereignisse oder Bedingungen verknüpft werden. Denkbar ist, dass ein erster vorgegebener Grenzwert nicht von der Abweichung e unterschritten und ein zweiter vorgegebener Grenzwert nicht überschritten werden darf. Bei Überschreiten der Grenzen kann ein Alarm ausgegeben werden und/oder eine Anpassung eines Signals erfolgen. Ein Alarm kann in optisch und/oder akustisch und/oder haptisch registrierbarer Form ausgegeben werden.

In einer weiteren Ausgestaltung des erfindungsgemäßen Verfahrens ist vorgesehen, dass das Soll-Strom-Signal mit einer ersten Abtastrate und das Ist-Strom-Signal mit einer in einem festen Verhältnis zur ersten Abtastrate stehenden zweitenAbtastrate digitalisiert werden. In einer Ausgestaltung der Erfindung kann dieses Verhältnis auch gleich 1 gewählt werden, das heißt die Abtastraten sind gleich. Um den Vergleich der Signale zu vereinfachen, ist es vorteilhaft, wenn sie mit in festem Verhältnis zueinander stehenden Frequenzen abgetastet werden. Sowohl die Kreuzkorrelation als auch die Autokorrelation müssen nur über eine geringe Zahl von Abtastwerten berechnet werden, wodurch sich der Rechenaufwand pro Vergleich reduziert.

Die zuvor hergeleitete und aufgezeigte Aufgabe ist nach einer weiteren Lehre der Erfindung bei dem eingangs genannten Feldgerät dadurch gelöst, dass die Steuerkomponente für den Vergleich eine Kreuzkorrelation des Soll-Strom-Signals mit dem Ist-Strom-Signal bildet.

Bei dem Feldgerät handelt es sich insbesondere um einen Aktor oder ein Messgerät. Die Steuereinheit wird insbesondere verwendet, um ein Verfahren nach einem der Ansprüche 1 bis 3 durchzuführen. Die folgenden Ausführungen zu den Ausgestaltungen eines erfindungsgemäßen Feldgerätes gelten entsprechend auch für das bereits beschriebene Verfahren.

In einer Ausgestaltung des erfindungsgemäßen Feldgerätes ist es vorgesehen, dass eine Umwandlungseinrichtung zur Umwandlung von digitalen Signalen zu analogen Signalen, insbesondere ein Digital-Analog-Wandler oder eine Vorrichtung zur Pulsweitenmodulation, vorhanden ist und dass hinter der Umwandlungseinrichtung ein analoges Filter, vorzugsweise ein Tiefpass mit einer Grenzfrequenz kleiner oder gleich 25 Hz, geschaltet ist. Sowohl die Umwandlungseinrichtung als auch das analoge Filter sind vor dem Signalausgang geschaltet.

Wenn das Soll-Strom-Signal von der Steuerkomponente erzeugt wird, wird es im Anschluss zu einem analogen Signal umgesetzt und danach mit dem Tiefpass gefiltert, bevor es über den Signalausgang ausgegeben wird. Nach dem Tiefpass können dem analogen Signal noch andere Signale überlagert werden. Eine Überlagerung nach dem HART-Standard wäre zum Beispiel denkbar, so dass das Signal mit weiteren Informationen ausgestattet wird. Natürlich beschränkt sich dieser Vorgang nicht auf die HART-Kommunikation.

Nach einer weiteren Ausgestaltung des erfindungsgemäßen Feldgerätes ist vorgesehen, dass ein Analog-Digital-Wandler vorhanden ist, der das eingelesene Ist-Strom-Signal digitalisiert.

Um das eingelesene Ist-Strom-Signal für die Steuerkomponente verarbeitbar zu machen, wird das rückgelesene Signal digitalisiert. Dabei kann, je nach Ausgestaltung, das Rücklesen direkt hinter dem Signalausgang realisiert werden oder aber an einer anderen Stelle, die das Signal passiert. Nach der Digitalisierung sind je nach Ausgestaltung weitere Bauteile eingebracht, die das Signal entsprechend bearbeiten. So kann ein digitales Filter verwendet werden, um ein gegebenenfalls vorhandenes HART-Signal auszufiltern. Dafür können FIR-Filter (Finite Impulse Response) verwendet werden.

In einer Ausgestaltung des erfindungsgemäßen Feldgerätes wird ein digitales Filter verwendet, um die hochfrequenten Überlagerungen eines vorhandenes HART-Signal auszufiltern. Bei der vorherigen Digitalisierung weist die Abtastrate des Ist-Strom-Signals eine höhere Frequenz auf als die Abtastrate des Soll-Strom-Signals. Vorteilhafterweise werden bei der höheren Abtastrate auch die hochfrequenten Signalanteile erfasst und diese werden anschließend digital ausgefiltert. Bei einer kleineren Abtastrate gehen die Informationen der hochfrequenten Signale verloren.

In einem weiteren Ausführungsbeispiel des erfindungsgemäßen Feldgerätes ist vorgesehen, dass ein digitales Filter als funktionelle Nachbildung des analogen Filters, der der Umwandlungseinrichtung nachgeschaltet ist, vorhanden ist, wobei das digitale Filter das digitalisierte Soll-Strom-Signal filtert.

Durch den digitalen Tiefpass wird das Soll-Strom-Signal an das Ist-Strom-Signal angeglichen. Ein zeitlicher Versatz, der durch zusätzliche Filter hervorgerufen wird, wird später bei der Durchführung der Kreuzkorrelation wieder ausgeglichen. Dennoch ist es sinnvoll, dass das Soll-Strom-Signal bereits vor der Umwandlungseinrichtung abgegriffen wird, damit gewährleistet wird, dass das Soll-Strom-Signal mit einem Ist-Strom-Signal verglichen wird und nicht mit einem Störsignal, das möglicherweise durch Übersprechen von unterschiedlichen Leitungen hervorgerufen wird.

Wie zuvor im Einzelnen dargelegt, gibt es verschiedene Möglichkeiten, das erfindungsgemäße Verfahren zum Betreiben eines Feldgerätes beziehungsweise das erfindungsgemäße Feldgerät auszugestalten und weiterzubilden. Dazu wird verwiesen auf die den Patentansprüchen 1 und 4 nachgeordneten Patentansprüche und auf die nachfolgende Beschreibung von Ausführungsbeispielen in Verbindung mit der Zeichnung. In der Zeichnung zeigen

Fig. 1    eine schematische Darstellung eines Ausführungsbeispiels des Feldgerätes,

Fig. 2    eine schematische Darstellung einer Ausgestaltung des Verfahrens zum Betreiben eines Feldgerätes und

Fig. 3    eine schematische Darstellung des Aufbaus einer Ausgestaltung des Feldgerätes.

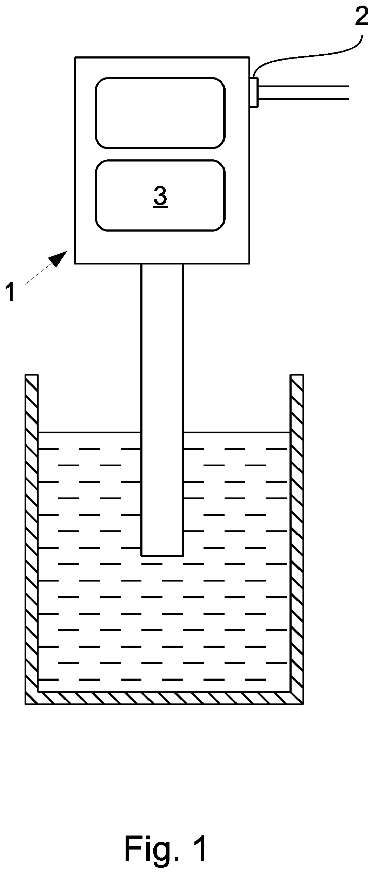

Fig. 1 zeigt ein Feldgerät 1 mit einem Stromausgang 2 und einer sich im Feldgerät 1 befindlichen Steuerkomponente 3. Bei dem in Fig. 1 dargestellten Feldgerät 1 handelt es sich um ein Temperaturmessgerät mit einem Temperaturmessfühler, der in einem Behälter mit einem Medium angeordnet ist, dessen Temperatur bestimmt werden soll. Über den Signalausgang 2 werden Strom-Signale ausgegeben, die Informationen über den Messwert enthalten. Ausgegebene Signale werden von dem Feldgerät 1 rückgelesen, so dass ein Soll-Strom-Signal mit einem Ist-Strom-Signal verglichen werden kann. Für den Vergleich der Signale dient die Steuerkomponente 3, die bei zu großen Abweichungen agiert. Dies kann je nach betragsmäßiger Höhe der Abweichung vom Soll-Strom-Wert zum Ist-Strom-Wert unterschiedlich sein. Bei geringen Abweichungen wird der Soll-Strom-Wert von der Steuerkomponente 3 angepasst. Bei höheren Abweichungen gibt die Steuerkomponente 3 ein akustisch und visuell wahrnehmbares Signal aus, das den Benutzer zum Handeln auffordert, sei es zu einer Reparatur oder zum Austausch des Feldgerätes 1.

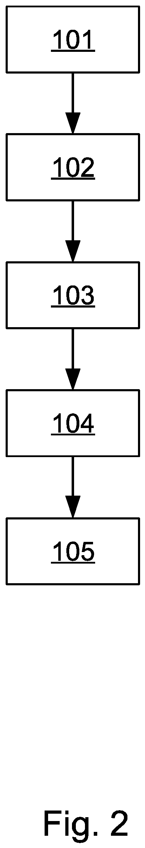

Fig. 2 zeigt den schematischen Ablauf für eine Ausgestaltung des Verfahrens zum Betreiben eines Feldgerätes. In Schritt 101 wird von dem Feldgerät ein Messwert erzeugt. Dies kann beispielsweise das Ergebnis einer Füllstandsmessung, einer Geschwindigkeitsmessung oder einer sonstigen Messung von physikalischen und/oder chemischen Zuständen sein. Der Messwert wird anschließend in Schritt 102 entsprechend dem bekannten 4...20 mA Standard nach DIN IEC 60381-1 einem Strom-Soll-Wert zugeordnet, der dann in Schritt 103 als Soll-Strom-Signal ausgegeben wird. Der Signalausgang ist als analoger Stromausgang ausgebildet. In Schritt 104 wird ein Ist-Strom-Signal vom Signalausgang eingelesen und in Schritt 105 mit dem Soll-Strom-Signal verglichen. Die Schritte 102 bis 105 werden von der Steuerkomponente des Feldgerätes koordiniert und durchgeführt.

Die Signale werden mit der gleichen Abtastrate digitalisiert, um die Vergleichbarkeit auf digitaler Ebene zu vereinfachen. Bei dem Vergleich des Soll-Strom-Signals mit dem Ist-Strom-Signal wird von der Steuerkomponente eine Kreuzkorrelation des Soll-Strom-Signals mit dem Ist-Strom-Signal durchgeführt. Ohne weitere Berechnungen kann aus der Kreuzkorrelation allein also eine Abweichung des Ist-Strom-Signals vom Soll-Strom-Signal als absoluter Fehler berechnet werden.

In diesem Ausführungsbeispiel wird allerdings ein relativer Fehler bestimmt. Dazu berechnet die Steuerkomponente eine Autokorrelation des Soll-Strom-Signals und setzt die Ergebnisse der Kreuzkorrelation mit den Ergebnissen der Autokorrelation ins Verhältnis, um eine Abweichung zu ermitteln.

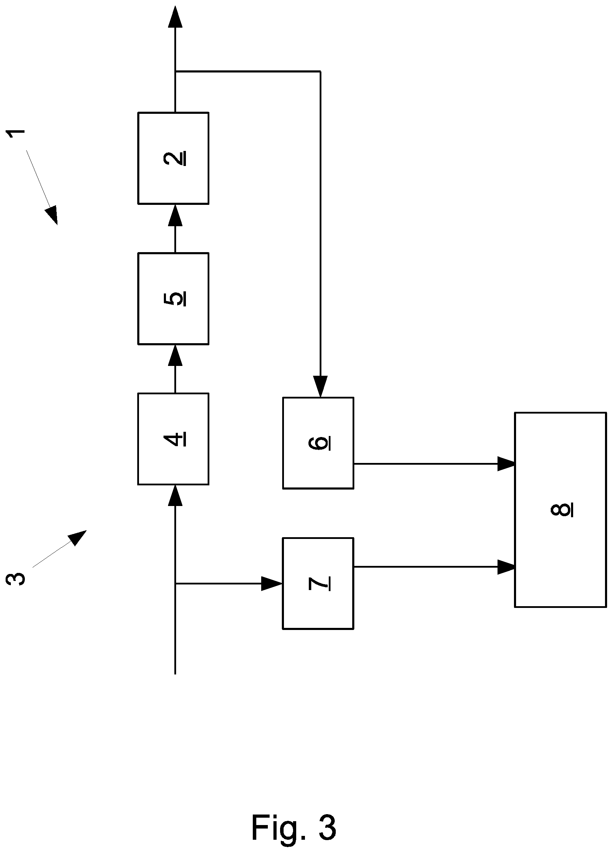

In Fig. 3 ist der schematische Aufbau eines Feldgerätes 1 zur Umsetzung des Verfahrens gemäß Fig. 2 dargestellt. In diesem Ausführungsbeispiel umfasst das Feldgerät 1 eine Umwandlungseinrichtung 4, die nach der Erzeugung des Soll-Strom-Signals das digitale Soll-Strom-Signal in ein analoges Signal umsetzt. Der Umwandlungseinrichtung 4 ist ein analoges Filter 5 nachgeschaltet. Dieses analoge Filter 5, hier ein Tiefpass, hat eine Grenzfrequenz von 25 Hz.

Das gefilterte Signal wird dann über den Signalausgang 2 ausgegeben und im Anschluss rückgelesen. Beim Rücklesen wird das Signal mit einem Analog-Digital-Wandler 6 digitalisiert, um eine einfachere Auswertung bzw. einen einfacheren Vergleich mit dem Soll-Strom-Signal zu ermöglichen.

Damit die Signale besser miteinander verglichen werden können, ist eine digitale Nachbildung 7 des analogen Filters 5 bzw. des Tiefpasses vorgesehen, die das eingestellte Soll-Strom-Signal filtert. Das Soll-Strom-Signal wird vor der Umwandlungseinrichtung 4 abgegriffen. Beide Signale, das digital gefilterte Soll-Strom-Signal sowie das rückgelesene Ist-Strom-Signal, werden im Anschluss von der Steuerkomponente 3 durch Berechnung der Kreuzkorrelation verglichen, wobei sie einer Recheneinheit 8 zugeführt werden.

**Patentansprüche**

1. Verfahren zum Betreiben eines Feldgerätes (1), wobei ein Messwert erzeugt wird, wobei dem Messwert ein Strom-Soll-Wert zugeordnet wird, wobei abhängig von dem Strom-Soll-Wert ein Soll-Strom-Signal ausgegeben wird, wobei ein Ist-Strom-Signal rückgelesen wird und das Soll-Strom-Signal mit dem Ist-Strom-Signal verglichen wird, **dadurch gekennzeichnet,** **dass** für den Vergleich eine Kreuzkorrelation des Soll-Strom-Signals mit dem Ist-Strom-Signal gebildet wird, sodass das Soll-Strom-Signal und das Ist-Strom-Signal, auch wenn sie zeitlich verschoben sind, leicht und präzise vergleichbar sind.

2. Verfahren nach Anspruch 1, **dadurch gekennzeichnet, dass** eine Autokorrelation des Soll-Strom-Signals oder des Ist-Strom-Signals gebildet wird und dass eine Abweichung (e) der korrelierten Signale berechnet wird, indem die Werte der Kreuzkorrelation des Ist-Strom-Signals mit dem Soll-Strom-Signal mit dem Wert der Autokorrelation des Strom-Soll-Wertes oder dem Wert der Autokorrelation des Ist-Strom-Signals zueinander ins Verhältnis gesetzt wird.

3. Verfahren nach Anspruch 1 oder 2, **dadurch gekennzeichnet, dass** das Soll-Strom-Signal mit einer ersten Abtastrate und das Ist-Strom-Signal mit einer in einem festen Verhältnis zur ersten Abtastrate stehenden zweiten Abtastrate digitalisiert werden.

4. Feldgerät (1) mit mindestens einem Signalausgang (2) und mit mindestens einer Steuerkomponente (3), wobei das Feldgerät (1) einen Messwert erzeugt, wobei die Steuerkomponente (3) dem Messwert einen Strom-Soll-Wert zuordnet, abhängig vom Strom-Soll-Wert ein Soll-Strom-Signal erzeugt und das Soll-Strom-Signal über den Signalausgang (2) ausgibt und wobei die Steuerkomponente (3) ein Ist-Strom-Signal rückliest und das Soll-Strom-Signal mit dem Ist-Strom-Signal vergleicht, **dadurch gekennzeichnet,** **dass** die Steuerkomponente (3) für den Vergleich eine Kreuzkorrelation des Soll-Strom-Signals mit dem Ist-Strom-Signal bildet, sodass das Soll-Strom-Signal und das Ist-Strom-Signal, auch wenn sie zeitlich verschoben sind, leicht und präzise vergleichbar sind.

5. Feldgerät (1) nach Anspruch 4, **dadurch gekennzeichnet, dass** eine Umwandlungseinrichtung (4) zur Umwandlung von digitalen Signalen zu analogen Signalen, insbesondere ein Digital-Analog-Wandler oder eine Vorrichtung zur Pulsweitenmodulation, vorhanden ist.

6. Feldgerät (1) nach Anspruch 5, **dadurch gekennzeichnet, dass** hinter der Umwandlungseinrichtung (4) ein analoges Filter (5), vorzugsweise ein Tiefpass mit einer Grenzfrequenzkleiner oder gleich 25 Hz, geschaltet ist.

7. Feldgerät (1) nach Anspruch 6, **dadurch gekennzeichnet, dass** ein digitales Filter (7) als funktionelle Nachbildung des analogen Filters (5) vorgesehen ist, wobei das digitale Filter (7) das Soll-Strom-Signal filtert.

8. Feldgerät (1) nach einem der Ansprüche 4 bis 7, **dadurch gekennzeichnet, dass** ein Analog-Digital-Wandler (6) vorhanden ist, der das eingelesene Ist-Strom-Signal digitalisiert.

**Claims**

1. Method for operating a field device (1), wherein a measured value is generated, wherein the measured value is assigned a current set point, wherein a target current signal is issued depending on the current set point, wherein an actual current signal is read back and the target current signal is compared to the actual current signal, **characterized in**
   **that**, a cross-correlation of the target current signal with the actual current signal is formed for comparison so that the target current signal and the actual current signal are easily and precisely comparable, even if they are temporally shifted.

2. Method according to claim 1, **characterized in that** an auto-correlation of the target current signal or of the actual current signal is formed and that a deviation (e) of the correlated signals is calculated **in that** the values of the cross-correlation of the actual current signal with the target current signal are put in relation to the value of the auto-correlation of the current set point or the value of the auto-correlation of the actual current signal.

3. Method according to claim 1 or 2, **characterized in that** the target current signal is digitized with a first sampling rate and the actual current signal is digitized with a second sampling rate that is set at a fixed relation to the first sampling rate.

4. Field device (1) having at least one signal outlet (2) and at least one control component (3), wherein the field device (1) generates a measured value, wherein the control component (3) assigns the measured value a current set point, generates a target current signal depending on the current set point and issues the target current signal via the signal outlet (2) and wherein the control component (3) reads an actual current signal back and compares the target current signal to the actual current signal, **characterized in**
   **that** the control component (3) forms a cross-correlation of the target current signal with the actual current signal for comparison so that the target current signal and the actual current signal are easily and precisely comparable, even if they are temporally shifted.

5. Field device (1) according to claim 4, **characterized in that** a converting device (4), in particular a digital-to-analog converter or a device for pulse width modulation, is provided for conversion from digital signals to analog signals.

6. Field device (1) according to claim 5, **characterized in that** an analog filter (5), preferably a low pass filter having a limit frequency less than or equal to 25 Hz, is connected behind the converting device (4).

7. Field device (1) according to claim 6, **characterized in that** a digital filter (7) is provided as functional replication of the analog filter (5), wherein the digital filter (7) filters the target current signal.

8. Field device (1) according to any one of claims 4 to 7, **characterized in that** an analog-to-digital converter (6) is provided that digitizes the imported actual current signal.

**Revendications**

1. Procédé pour faire fonctionner un appareil de terrain (1), dans lequel une valeur de mesure est générée, dans lequel une valeur de courant nominale est associée à la valeur de mesure, dans lequel un signal de courant nominal est délivré en fonction de la valeur de courant nominale, dans lequel un signal de courant réel est relu et le signal de courant nominal est comparé au signal de courant réel,

**caractérisé en ce qu'**une intercorrélation entre le signal de courant nominal et le signal de courant réel est établie pour la comparaison de manière à ce que le signal de courant nominal et le signal de courant réel, même s'ils sont décalés dans le temps, puissent être facilement et précisément comparés.

2. Procédé selon la revendication 1, **caractérisé en ce qu'**une autocorrélation du signal de courant nominal ou du signal de courant réel est établie et **en ce qu'**un écart (e) des signaux corrélés est calculé en déterminant le rapport des valeurs de l'intercorrélation entre le signal de courant réel et le signal de courant nominal à la valeur de l'autocorrélation de la valeur de courant nominale ou à la valeur de l'autocorrélation du signal de courant nominal.

3. Procédé selon la revendication 1 ou 2, **caractérisé en ce que** le signal de courant nominal est numérisé à une première fréquence d'échantillonnage et **en ce que** le signal de courant réel est numérisé à une seconde fréquence d'échantillonnage qui présente un rapport fixe à la première fréquence d'échantillonnage.

4. Appareil de terrain (1) comportant au moins une sortie de signal (2) et au moins un composant de commande (3), dans lequel l'appareil de terrain (1) génère une valeur de mesure, dans lequel le composant de commande (3) associe une valeur de courant nominale à la valeur de mesure, génère un signal de courant nominal en fonction de la valeur de courant nominale et délivre le signal de courant nominal par l'intermédiaire de la sortie de signal (2) et dans lequel le composant de commande (3) relit un signal de courant réel et compare le signal de courant nominal au signal de courant réel,

**caractérisé en ce que** le composant de commande (3) établit une intercorrélation entre le signal de courant nominal et le signal de courant réel pour la comparaison

de manière à ce que le signal de courant nominal et le signal de courant réel, même s'ils sont décalés dans le temps, puissent être facilement et précisément comparés.

5. Appareil de terrain (1) selon la revendication 4, **caractérisé en ce qu'**il est prévu un dispositif de conversion (4) destiné à convertir des signaux numériques en signaux analogiques, notamment un convertisseur numérique-analogique ou un dispositif de modulation d'impulsions en largeur.

6. Appareil de terrain (1) selon la revendication 5, **caractérisé en ce qu'**un filtre analogique (5), de préférence un filtre passe-bas ayant une fréquence de coupure inférieure ou égale à 25 Hz, est connecté en aval du dispositif de conversion (4).

7. Appareil de terrain (1) selon la revendication 6, **caractérisé en ce qu'**il est prévu un filtre numérique (7) en tant qu'équivalent fonctionnel du filtre analogique (5), dans lequel le filtre numérique (7) filtre le signal de courant nominal.

8. Appareil de terrain (1) selon l'une des revendications 4 à 7, **caractérisé en ce qu'**il est prévu un convertisseur analogique-numérique (6) qui numérise le signal de courant réel lu en entrée.

Fig. 1

Fig. 2

Fig. 3

**IN DER BESCHREIBUNG AUFGEFÜHRTE DOKUMENTE**

**In der Beschreibung aufgeführte Patentdokumente**

- DE 19930661 A1